# EUROPÄISCHE PATENTANMELDUNG

(11) **EP 4 177 619 A1**
(43) Veröffentlichungstag der Anmeldung: **10.05.2023**
(21) Anmeldenummer: 21206492.7
(22) Anmeldetag: 04.11.2021
(51) Int. Cl.: G01R 31/367, G01R 31/392

(54) **VORRICHTUNG UND VERFAHREN ZUM KONFIGURIEREN EINER STEUEREINRICHTUNG FÜR EINEN BATTERIESPEICHER**

(71) Anmelder: Siemens Aktiengesellschaft, 80333 München (DE)
(72) Erfinder: Steinbacher, Frank, 90542 Eckental (DE); Weber, Marc Christian, 80339 München (DE)
(74) Vertreter: Siemens Patent Attorneys

(57) **Zusammenfassung**

Die Erfindung beansprucht eine Computerimplementiertes Verfahren zum Konfigurieren einer Steuereinrichtung für einen Batteriespeicher, wobei
a) eine Erfassungseinrichtung bereitgestellt wird, die dazu ausgestaltet ist, Ground-Truth-Werte von am Batteriespeicher gemessenen physikalischen Größen über einen vorgebbaren Nutzungszeitraum zu erfassen,
b) ein Simulationsmodul, gegebenenfalls unter Verwendung eines elektrischen und/oder thermisches Modells, bereitgestellt wird, das dazu ausgelegt ist, anhand von als Simulationseingabedaten eingespeisten an demselben Batteriespeicher oder an zumindest einem weiteren vergleichbaren Batteriespeicher gemessenen und/oder angenommenen Leistungsprofilen über einen mit dem Nutzungszeitraum vergleichbaren, vorgebbaren Zeitraum das Verhalten des Batteriespeichers und den erfassten und/oder vorgebbarer Ground-Truth-Werten elektrisch und/oder thermisch zu simulieren und aus der Simulation gewonnene zeitliche Verläufe von physikalischen Größen über den ganzen Zeitraum oder Teile des Zeitraums als Simulationsausgabedaten auszugeben,
c) durch das Simulationsmodul eine elektrische und/oder thermische Simulation anhand der Simulationseingabedaten durchgeführt wird und dabei die Simulationsausgabedaten ermittelt werden,
d) die Simulationsausgabedaten und die erfassten und/oder vorgebbaren Ground-Truth-Werte als Eingabedaten in ein neuronales Netz eingespeist werden,
e) das neuronale Netz darauf trainiert wird, einen aus den Eingabedaten bestimmbaren Batterieladezustand und/oder bestimmbaren Alterungszustand des Batteriespeichers zu prognostizieren und als Ausgabedaten zur Konfiguration der Steuereinrichtung auszugeben.

## Beschreibung

Die Erfindung betrifft ein computer-implementiertes Verfahren und eine Vorrichtung zum Konfigurieren einer Steuereinrichtung für einen Batteriespeicher sowie ein zugehöriges Computerprogrammprodukt.

Stationäre und mobile Batteriespeicher unterliegen im Feldeinsatz nicht-trivialen Alterungsmechanismen, die, je nach Benutzung und Umgebungsbedingungen, die Speicherkapazität und Leistungsfähigkeit des Batteriespeichers mit der Zeit herabsetzen. Batteriespeicher können sich aus mehreren Batteriezellen zusammensetzen oder auch ein Konglomerat von mehreren Batteriespeichern sein. Bislang muss sich der Besitzer/Betreiber des Batteriespeichers während des Betriebs häufig auf abgeschätzte Lade- (State-of-Charge, SOC) und Gesundheits-/Alterungszustände (State-of-Health, SOH, Funktion von Speicherkapazität und Innenwiderständen) des oft dazugehörigen Batteriemanagementsystems (BMS) verlassen. Häufig wird das Batteriemanagementsystem vom Batteriezellhersteller mit zur Verfügung gestellt und ist somit nicht transparent in seinen Berechnungen und deren Ungenauigkeiten. Aus Erfahrungen mit stationären Batteriespeichern im Feldbetrieb hat sich gezeigt, dass der aktuelle Ladezustand deswegen häufig eine Ungenauigkeit von +- 2% SOC und der Gesundheitszustand von +-3% SOH besitzen kann. Bei der Abschätzung des Gesundheitszustands ist das besonders drastisch, da sich der gesamte nutzbare Bereich des Speichers lediglich von 100% SOH bis 70% SOH erstreckt. Dies hat zur Folge, dass die Ungenauigkeit im Monitoring der Speichereigenschaften durch eine Überdimensionierung des Batteriespeichers kompensiert wird. Zudem wird der Batteriespeicher möglichst konservativ betrieben, da zum einen die Konsequenzen bestimmter Lastzyklen (Zellalterung der Batteriezellen) für den Betreiber nicht klar ersichtlich sind (ungenauer SOH-Wert) und zum anderen aufgrund des Unwissens über den genauen Ladezustand die Leistungserbringung des Batteriespeichers begrenzt wird.

Deshalb werden zur Steuerung von Batteriespeichern in zunehmendem Maße Simulationsverfahren eingesetzt, die ein physisches Verhalten des Batteriespeichers simulieren. Das Verhalten von Batteriespeichern (https://de.wikipedia.org/wiki/Elektrisches_Bauelement) ist oft abhängig von mehreren Einflussgrößen (in der Regel: Stromstärke und/oder Spannung und/oder Temperatur) und muss durch mehrere Parameter beschrieben werden. Nichtlineare Zusammenhänge erschweren die mathematische Behandlung. Als eine Möglichkeit zur Erstellung eines Simulationsmodells werden häufig datenbasierte Verfahren des maschinellen Lernens eingesetzt. Hierbei werden insbesondere künstliche neuronale Netze darauf trainiert, ausgehend von Betriebsdaten des zu simulierenden Systems ein resultierendes physisches Verhalten des Systems zu reproduzieren und damit zu simulieren. Für ein erfolgreiches Training werden jedoch in der Regel große Mengen von Betriebsdaten des Systems, in diesem Kontext des Batteriespeichers, als Trainingsdaten benötigt. Die Trainingsdaten sollten zudem die Zustände und Betriebsbedingungen des Batteriespeichers möglichst repräsentativ abdecken.

Alle vom Batteriemanagementsystem (abgekürzt: BMS) zur Verfügung gestellten Daten (Strom, Spannung, Temperatur der Batteriemodule und evtl. der einzelnen Zellen) werden als Zeitreihen zu übertragen. Darauf komplexe Analysen (z.B. Machine Learning) zum Zustand des Speichers können in einer Cloud behandelt werden. Hierbei stellen häufig die geringe Anzahl und Varianz der Betriebsdaten (wenige Speicher; immer ähnliches Lastprofil) und das Fehlen von tatsächlichen Ground-Truth-Werten (übersetzt in etwa "Bodenwirklichkeit", treffender mit Feldvergleich zu benennen) für Speicherkapazität, Ladezustand und Innenwiderstände der Zellen Probleme dar, die die Nutzung des Maschinellen Lernens behindern.

Zudem kann das Batteriemanagementsystem, das in der Regel auf einem Microcontroller mit geringem Speicher basiert, eine komplexe Analyse bzw. Simulation des Batteriespeicherverhaltens nicht leisten.

Die Aufgabe der Erfindung besteht darin, ein gegenüber des eingangs genannten Standes der Technik verbessertes Verfahren sowie eine verbesserte Steuereinrichtung bzw. Vorrichtung anzugeben.
Diese Aufgabe wird durch die unabhängigen Ansprüche gelöst. Vorteilhafte Weiterbildungen sind Gegenstand der abhängigen Ansprüche.

Die Erfindung beansprucht eine Computerimplementiertes Verfahren zum Konfigurieren einer Steuereinrichtung für einen Batteriespeicher, wobei
a) eine Erfassungseinrichtung bereitgestellt wird, die dazu ausgestaltet ist, Ground-Truth-Werte von am Batteriespeicher gemessenen physikalischen Größen über einen vorgebbaren Nutzungszeitraum zu erfassen,
b) ein Simulationsmodul, gegebenenfalls unter Verwendung eines elektrischen und/oder thermisches Modells, bereitgestellt wird, das dazu ausgelegt ist, anhand von als Simulationseingabedaten eingespeisten an demselben Batteriespeicher oder an zumindest einem weiteren vergleichbaren Batteriespeicher gemessenen und/oder angenommenen Leistungsprofilen über einen mit dem Nutzungszeitraum vergleichbaren, vorgebbaren Zeitraum das Verhalten des Batteriespeichers und den erfassten und/oder vorgebbarer Ground-Truth-Werten elektrisch und/oder thermisch zu simulieren und aus der Simulation gewonnene zeitliche Verläufe von physikalischen Größen über den ganzen Zeitraum oder Teile des Zeitraums als Simulationsausgabedaten auszugeben,
c) durch das Simulationsmodul eine elektrische und/oder thermische Simulation anhand der Simulationseingabedaten durchgeführt wird und dabei die Simulationsausgabedaten ermittelt werden,
d) die Simulationsausgabedaten und die erfassten und/oder vorgebbaren Ground-Truth-Werte als Eingabedaten in ein neuronales Netz eingespeist werden,
e) das neuronale Netz darauf trainiert wird, einen aus den Eingabedaten bestimmbaren Batterieladezustand und/oder bestimmbaren Alterungszustand des Batteriespeichers zu prognostizieren und als Ausgabedaten zur Konfiguration der Steuereinrichtung auszugeben.

Gemäß einer Weiterbildung der Erfindung misst und/oder erfasst die Steuereinrichtung (EMS), welche einen internen und/oder externen Speicher aufweist, in dem das trainierte neuronale Netz vollständig oder zumindest in einer Speicherplatz-optimierten Form bereitgestellt wird, im Batteriespeicherbetrieb (Feld) die physikalischen Größen und prognostiziert mittels des Neuronalen Netzes ein oder mehrere Batterieladezustände und Alterungszustände und nutzt diese dazu, ein oder mehrere Steuermaßnahmen einzuleiten, wenn ein vorgebbarer Grenzwert für den Batterieladezustand und/oder Alterungszustand erreicht wird.

Durch die Konfiguration der Steuereinrichtung können die eine oder mehrere Steuerungsmaßnahmen den Betrieb des Batteriespeichers derart beeinflussen, dass seine Lebensdauer verlängert wird. Bei einer künftigen Batteriespeicherdimensionierung kann das berücksichtigt werden und die Dimensionierung verringert werden. Eine Steuerungsmaßnahme kann z.B. eine Stromzufuhr/-abfuhr starten/stoppen bzw. auch einfach eine Warnmeldung ausgeben.

Eine Erfassungseinrichtung kann als Eingabeeinheit oder als Sensoreinheit ausgestaltet sein.

Wenn an demselben Batteriespeicher die Leistungsprofile gemessen oder angenommen werden, dann sind es in der Regel Leistungsprofile, die im Batteriespeicherbetrieb im Feldversuch/-einsatz gewonnen wurden. Wenn die Leistungsprofile an einem ähnlichen/vergleichbaren Batteriespeicher gemessen oder angenommen, bzw. auch ableitet oder geschätzt werden, dann sind es in der Regel Leistungsprofile, die aus einem Laborversuch/-einsatz gewonnen wurden. Leistungsprofile können auch ohne Feldeinsatz bzw. Laborversuch synthetisch erzeugt werden.

Ground-Truth-Werte können wie unter a) erfasst oder vordefiniert bzw. manuell vorgegeben bzw. aufgrund von Erfahrungswerten bzw. historischer Daten festgelegt werden.

Das Leistungsprofil kann auch aus einem Lastprofil stammen, das je nach Zeitachse, auch Tages- oder Jahresgang den zeitlichen Verlauf der abgenommenen elektrischen Leistung über eine zeitliche Periode (wiederholbar) bzw. Zeitraum beschreibt. Die physikalischen Größen umfassen in der Regel Strom-, Spannung- und Temperaturverlauf über einen vorgebbaren Zeitraum/Periode.

Als Verfahren für eine solche Simulation, die im Simulationsmodul durchgeführt werden kann, wird häufig ein Ersatzschaltbild zur Vereinfachung der Wirklichkeit verwendet. Für das Ersatzschaltbild werden in der Schaltungstheorie Modelle idealer Bauelemente definiert, die in ihrer Perfektion nicht existieren, aber die Beschreibung des realen Verhaltens des Batteriespeichers und die mathematische Behandlung erleichtern. Die Nachbildung des realen Verhaltens erfordert die Ersatzschaltung aus mehreren idealisierten Elementen. Zu diesen zählen die Spannungsquelle, die Stromquelle und die linearen Widerstände. Es werden häufig analytische Ersatzschaltbildmodelle verwendet und z.B. mit Kalman-, Partikelfiltern oder Least-Squares-Fit-Methoden auf Strom-Spannungs-Temperatur-Daten angewendet, um die vom Batteriemanagementsystem übermittelten SOC- und SOH-Werte zu bestätigen.

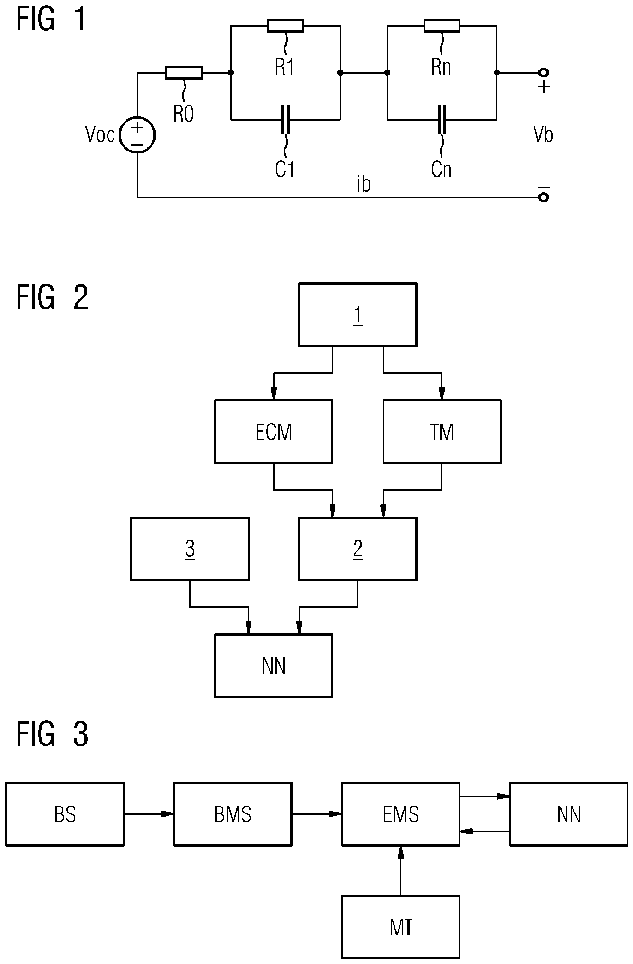

In Figur 1 ist beispielsweise das sogenannte Thevenin Ersatzschaltungsmodell mit zwei RC-Gliedern gezeigt. Dabei repräsentieren Voc die Leerlaufspannung, Vb die Spannung zwischen Plus- und Minuspol der Batterie, ib die Stromstärke, R0, R1 und Rn Widerstände und C1, Cn Kondensatoren.

Die Ausgabedaten des neuronalen Netzes können in das Simulationsmodul als Simulationseingabedaten eingespeist werden und die Schritte b) bis e) gegebenenfalls wiederholt werden.

Vor oder während der Simulation des Verhaltens des Batteriespeichers können für den Betrieb des Batteriespeichers relevante Parameter, insbesondere Speicherkapazität, Innenwiderstand, Ruhepotential, elektrische Impedanz und/oder Alterungszustandsraten eingestellt werden. Damit kann eine Lücke zwischen Labor- und Felddaten weiter verringert werden.

Als mögliche weitere Eingabedaten können Betriebszustände- bzw. -bedingungen bzw. sensorische Daten, insbesondere Umgebungstemperatur, und/oder Batteriedesigninformationen, insbesondere geometrischer Aufbau und/oder elektrische Verschaltung von Batteriezellen und/oder -modulen angeschlossener Wechselrichtertyp, kumulierte Lastdauer und/oder kumulierte Ruhepausen in das neuronale Netz zusätzlich eingespeist werden.

Erfindungsgemäß wird nun ein neuronales Netz mit dem Ziel trainiert, einen aus den aus der Simulation gewonnenen zeitlichen Verläufen von physikalischen Größen bestimmbaren Batterieladezustand (SOC) und/oder bestimmbaren Alterungszustand (SOH) des Batteriespeichers zu optimieren.
Damit werden eine fehlenden Datenvielfalt und fehlende Ground-Truth-Werte gemäß des eingangs erwähnten Standes der Technik überwunden. Es wird mit der vorgeschalteten Simulation eine sinnvolle und genaue Verwendung von Methoden des Maschinellen Lernens mittels eines Neuronalen Netze ermöglicht.

Zum Training werden diese Größen in zeitlicher Abfolge in das neuronale Netz (NN) als Eingabedaten eingespeist. Als weitere Eingabedaten können gegebenenfalls Umgebungsdaten über eine Umgebung des Batteriespeichers in das neuronale Netz NN eingespeist werden. Die Umgebungsdaten können insbesondere eine Umgebungstemperatur, Wetterdaten, Zeitangaben und/oder Datumsangaben und den Wechselrichtertyp umfassen.

Als neuronales Netz können z.B. ein rekurrentes Neuronales Netz, Convolutional Neural Network (CNN) oder Temporal Coherent CNNs genutzt werden.

Das Training des neuronalen Netzes NN erfolgt vorzugsweise mittels eines Verfahrens des maschinellen bestärkenden Lernens. Unter einem Training sei hierbei allgemein eine Optimierung einer Abbildung von Eingabedaten eines neuronalen Netzes, auf Ausgabedaten, verstanden. Diese Abbildung wird nach vorgegebenen, gelernten und/oder zu lernenden Kriterien während einer Trainingsphase optimiert. Als Kriterien können hierbei z. B. bei Steuermodellen ein Erfolg einer Steueraktion, bei Prädiktionsmodellen ein Prädiktionsfehler oder bei Simulationsmodellen - wie im vorliegenden Fall - ein Simulationsfehler herangezogen werden.

Durch das Training können beispielsweise Vernetzungsstrukturen von Neuronen des neuronalen Netzes und/oder Gewichte von Verbindungen zwischen den Neuronen so eingestellt bzw. optimiert werden, dass die vorgegebenen Kriterien möglichst gut erfüllt werden. Das Training kann somit als Optimierungsproblem aufgefasst werden. Für derartige Optimierungsprobleme auf dem Gebiet des maschinellen Lernens sind eine Vielzahl von effizienten Optimierungsverfahren verfügbar.

Im vorliegenden Kontext werden der bestimmbare Batterieladezustand (SOC) und/oder der bestimmbare Alterungszustand (SOH) des Batteriespeichers prognostiziert. Die Prognose soll optimal in dem Sinne sein, dass ein ausreichend guter Schätzwert von SOC/SOH mit minimaler Abweichung bzw. Abstand von einem Ground-Truth-Wert erreicht wird.

Mit Hilfe des trainierten Neuronalen Netzes und der vom Neuronalen Netz gelieferten Ausgabedaten ist die Steuerungseinrichtung mit gegenüber dem Stand der Technik quantitativ und qualitativ besseren Informationen versorgt und kann den Batteriespeicher für die nächsten Lastprofile optimieren. Dadurch kann ggf. die Dimensionierung des Speichers verringert und/oder die Lebensdauer des Speichers verlängert werden. Durch die Simulationsausgabedaten und den erfassten Ground-Truth-Werten können mit dem gelernten Neuronalen Netz verlässliche Zustände prognostiziert und/oder Lastprofile im Batteriespeicherbetrieb hervorgebracht werden.

Zusätzlich kann rechtzeitig vor sich beschleunigenden Alterungsprozessen gewarnt werden, so dass verfrühte Ausfälle von einzelnen Batteriezellen oder des gesamten Batteriespeichers verhindert werden können.

In der Steuerungseinrichtung mit Hilfe des neuronalen Netzes abgeschätzte bzw. abgeleitete bzw. prognostizierte Zustände (SOC, SOH) des Batteriespeichers können einem (lokalen) Energiemanagementsystem zurückgespielt werden, wodurch es z.B. in der Lage ist, die Aufwendungen für den Betrieb in naher Zukunft z.B. in Form von reduzierten Lebensdauertagen zu prognostizieren und dem Gewinn durch den Betrieb gegenüberzustellen. Auf dieser Grundlage kann das Energiemanagementsystem beispielsweise Entscheidungen für eine Regelleistungserbringung, Peak Shaving, Vorladespeicherung oder Energiehandel treffen.

Damit kann der Batteriespeicher auch wirtschaftlich betrieben werden.

Ein weiterer Aspekt der Erfindung sieht eine Vorrichtung zum Konfigurieren einer Steuereinrichtung für einen Batteriespeicher vor, umfassend:
a) eine Erfassungseinrichtung, die dazu ausgestaltet ist, Ground-Truth-Werte von am Batteriespeicher gemessenen physikalischen Größen über einen vorgebbaren Nutzungszeitraum zu erfassen,
b) ein Simulationsmodul, das dazu ausgelegt ist, anhand von als Simulationseingabedaten eingespeisten an demselben Batteriespeicher oder an zumindest einem weiteren vergleichbaren Batteriespeicher gemessenen und/oder angenommenen Leistungsprofilen über einen mit dem Nutzungszeitraum vergleichbaren, vorgebbaren Zeitraum das Verhalten des Batteriespeichers und den erfassten und/oder vorgebbarer Ground-Truth-Werte elektrisch und/oder thermisch zu simulieren und aus der Simulation gewonnene zeitliche Verläufe von physikalischen Größen über den ganzen Zeitraum oder Teile des Zeitraums als Simulationsausgabedaten auszugeben,
c) ein mit der Vorrichtung gekoppeltes neuronales Netz, in das die Simulationsausgabedaten und die erfassten und/oder vorgebbaren Ground-Truth-Werte als Eingabedaten eingespeist werden können und
d) das darauf trainiert wird, einen aus den Eingabedaten bestimmbaren Batterieladezustand und/oder bestimmbaren Alterungszustand des Batteriespeichers zu prognostizieren und als Ausgabedaten zur Konfiguration der Steuereinrichtung auszugeben.

Eine mit der Vorrichtung gekoppelte Steuereinrichtung (EMS), welche einen internen und/oder externen Speicher aufweist, der das trainierte neuronale Netz vollständig oder zumindest in einer Speicherplatz-optimierten Form umfasst, kann im Batteriespeicherbetrieb die physikalischen Größen messen und/oder erfassen und mittels des Neuronalen Netzes ein oder mehrere Batterieladezustände und Alterungszustände prognostizieren und diese dazu nutzen, ein oder mehrere Steuermaßnahmen einzuleiten, wenn ein vorgebbarer Grenzwert für den Batterieladezustand und/oder Alterungszustand erreicht wird.

Die Module bzw. Einheiten bzw. die Ein- /Vorrichtung, die dazu eingerichtet sind, solche Verfahrensschritte auszuführen, können hardware-, firmware- und/oder softwaremäßig implementiert sein.

Ein weiterer Aspekt der Erfindung ist ein Computerprogramm(-produkt) mit Programmcodemitteln zur Durchführung des Verfahrens, wenn es auf einer Vorrichtung der oben genannten Art abläuft oder auf einem computerlesbaren Speichermedium gespeichert ist.

Das Computerprogramm bzw. -produkt kann auf einem computerlesbaren Speichermedium gespeichert sein. Das Computerprogramm bzw. -produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Steuereinrichtung oder in deren Mitteln integriert sein.

Die Vorrichtung sowie das Computerprogramm(-produkt) können analog zum oben genannten Verfahren und dessen Weiterbildungen weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.
Figur 1 zeigt das zuvor beschriebene Thevenin-Ersatzschaltungsmodell,
Figur 2 zeigt schematisch ein Ablaufdiagramm, wie ein Neuronales Netz trainiert werden kann,
Figur 3 zeigt schematisch ein Diagramm, wie das trainierte Neuronale Netz für den Betrieb des Batteriespeichers genutzt werden kann.
Figur 2 zeigt schematisch ein Ablaufdiagramm, wie ein Neuronales Netz trainiert werden kann.

Es werden die erfassten Messdaten aus dem Feld (Ground-Truth-Werte) um zusätzliche Metadaten und Lastprofile basierend auf Einzelzellmessungen in einem Labor ergänzt.

Gemäß Schritt 1 werden von einem vergleichbarerer Batteriespeicher neue, ungealterte Batteriezellen des gleichen Typs wie im Feld im Labor umfassend elektrisch und thermisch charakterisiert. Ihr Verhalten wird mit Hilfe eines oder mehrerer thermischer Zellmodelle TM und elektrischen Ersatzschaltbildmodellen EMC modelliert bzw. simuliert. Hierfür werden physikalische Größen wie Strom-, Spannungs- und Temperaturverläufe (Zelloberfläche) bei ggf. unterschiedlichen Umgebungstemperaturen und Betriebsbedingungen erfasst und als Simulationsdaten ausgegeben (Schritt 2). Beispiele der zu bestimmenden Messgrößen vor oder während der Simulation des Verhaltens des Batteriespeichers für den Betrieb des Batteriespeichers sind:
- Speicherkapazität bei Normbedingungen
- Parameter eines elektrischen Ersatzschaltbilds (Equivalent Circuit Model, ECM, z.B. Thevenin; wobei andere Schaltbilder möglich sind) in Abhängigkeit von Strombelastung, Temperatur und Ladezustand
- Ruhepotential der Zelle (OCV oder VOC) in Abhängigkeit von Temperatur und Ladezustand
- Elektrische Impedanzmessungen bei verschiedenen Temperaturen und Ladezuständen
   - Alterungsraten bei gegebenem Arbeitspunkt

Aus dem Ruhepotential können zusätzlich noch die Halbzellpotentiale für Anode und Kathode der Zelle mit Hilfe von Literaturdaten abgeschätzt werden. Daten aus Alterungsexperimenten können hierbei ebenfalls mit einfließen.

Sind die umfassenden elektrischen bzw. thermischen Modelle, beispielsweise implementiert in einem Simulationsmodul, parametriert, kann eine Vielzahl von künstlichen Batteriespeichern simuliert werden, die verschiedenste Lastprofile erbringen und während deren Betrieb die relevanten Parameter wie Speicherkapazität, Innenwiderstände und Ruhespannungspotentiale gezielt geändert werden. Hierdurch kann eine große Menge von verschiedenen Betriebsdaten zusammen mit den tatsächlichen Ground-Truth-Werten (für SOC und SOH) als Eingabedaten bereitgestellt werden, welche für das Anlernen bzw. Trainieren eines Neuronalen Netzes NN. (z.B. rekurrentes Neuronales Netz, Convolutional Neural Network (CNN) oder Temporal Coherent CNNs) genutzt werden. Das Trainieren des Neuronalen Netzes kann iterativ mittels einer Rückkopplung der Ausgabedaten des Neuronalen Netzes und erneutem Einspeisen dieser Daten als Eingabedaten evtl. mit wiederholten Simulationsausgabendaten in dasselbe Neuronale Netz durchgeführt werden.

Während das Anlernen des Neuronalen Netzes beispielsweise in einer Cloud passiert, besteht danach die Möglichkeit, die Zustandsschätzungen von Batteriespeichern ebenfalls in der Cloud (externer Speicher) durchzuführen oder eine reduzierte Version des Neuronalen Netzes auf einen lokalen Speicher z.B. Speicher eines Batteriemanagementsystems BMS, das Funktionen der Steuereinrichtung EMS umfassen kann, bzw. in einem lokalen, dedizierten Edge Device, beispielsweise einer Steuereinrichtung EMS, zu deren Konfiguration zurückzuspielen. Hierdurch müssten die Betriebsdaten des Batteriespeichers nicht mehr zeitnah in die Cloud übertragen werden.

Als zusätzliche Informationsquellen bzw. Eingabedaten können in Schritt 3 zusätzliche Metainformationen über die Speicher, z.B. Indoor/Outdoor-Nutzung oder angeschlossener Wechselrichtertyp, oder auch aus dem Lastprofil abgeleitete Features (z.B. kumulierte Zeiten, in denen der Speicher pausiert / mit 50% / 100% maximaler Last betrieben wird) mit in das Training des Neuronalen Netzes NN mit einbezogen werden.

Während des Trainingsprozesses wird außerdem festgelegt, wie lang die Datenhistorie für jede Zustandsabschätzung sein muss, ob beispielsweise die Daten der letzten Minute ausreichen, um eine verlässliche Schätzung für SOC und SOH durchzuführen.

Damit wird dem Besitzer/Betreiber des Batteriespeichers eine Möglichkeit gegeben, mit relativ geringem Messaufwand im Labor (keine umfangreichen Alterungsexperimente), die Zustände seiner Batteriespeicher im Feld in der Cloud und/oder Edge Device sehr genau mit Hilfe des trainierten Neuronalen Netzes zu bestimmen oder zu kontrollieren. Somit wird transparenter, wie genau der Speicher schon gealtert ist, was der Alterungsmechanismus ist (aus Verschiebung von Anoden- und Kathodenpotential möglich), wie viel ihn eine bestimmte Art des Betriebs an Verlust an Lebensdauer des Batteriespeichers kostet, wie viel Sicherheitsabstand er zu garantierten Leistungswerten noch besitzt und wie weit weg er sich noch von den tatsächlichen Betriebsgrenzen des Batteriespeichers befindet. Hierdurch kann während der Planungsphase eine realitätsnahe Dimensionierung des Batteriespeichers vorgenommen und unnötige Sicherheitsmargen reduziert werden.

Figur 3 zeigt schematisch ein Diagramm, wie das trainierte Neuronale Netz NN für den Betrieb des Batteriespeichers BS mit zugehörigem Batteriemanagementsystem BMS - wie z.B. eingangs bereits erwähnt - genutzt werden kann.

Eine mögliche Anwendung des trainierten Neuronalen Netzes NN könnte folgendermaßen aussehen:
1. Die Betriebsdaten des Batteriespeichers in einer bestimmten zeitlichen Abfolge z.B. sekündlicher Auflösung werden in zeitlichen Abständen z.B. alle X Minuten in die Cloud (bzw. zum Edge Device) geladen. Weitere Informationen MI können neben den Betriebsdaten als zusätzliche Rückmeldungen des Neuronalen Netzes oder nachgelagerte Berechnungen in der Steuereinrichtung EMS mit den Ausgabedaten des Neuronalen Netzes in die Cloud (bzw. zum Edge Device) geladen werden.
2. Dort läuft in festen Zeiträumen-/perioden oder vor bestimmten Trigger-Zeitpunkten eine Analyse zum Zustand des Batteriespeichers mit Hilfe des in der Cloud oder im Edge-Device gespeicherten Neuronalen Netzes (z.B. rekurrenten Neuronalen Netzes, Convolutional Neural Network (CNN) oder Temporal Coherent CNN) ab.
3. Die aktuellen SOH- und SOC-Werte werden an die Steuereinrichtung EMS des Speichers übergeben. Die Steuereinrichtung EMS kann derart konfiguriert werden/sein, dass bei Erreichen vorgebbarer Grenzwerte für den Batterieladezustand (SOC) und/oder Alterungszustand (SOH die Steuereinrichtung eine oder mehrere entsprechende Steuerungsmaßnahmen einleitet. Damit kann z.B. die Optimierung für das nächste Betriebsintervall angestoßen werden.
4. Zusätzlich können noch weitere Information wie z.B. mittlere Abweichungen zwischen BMS-Werten und Schätzwerten (z.B. SOC), SOH-Verlust pro Zyklus unter den letzten Bedingungen, Informationen zu den Alterungsmechanismen der Zellen und entstandene Asymmetrien zwischen einzelnen Batteriezellen oder Batteriespeicherracks analysiert werden.
5. Auf Basis der Informationen aus 3. und 4. ist die Steuerungseinrichtung mit besseren Informationen versorgt und kann entsprechende Steuerungsmaßnahmen z.B. Starten bzw. Stoppen der Stromzufuhr/-abfuhr einleiten. So kann der Batteriespeicher für die nächsten Lastprofile optimiert werden. Damit kann die Lebensdauer des Speichers verlängert werden und eine Dimensionierung des Speichers besser geplant werden.
   Als weitere Steuerungsmaßnahme kann rechtzeitig vor sich beschleunigenden Alterungsprozessen gewarnt werden, so dass verfrühte Ausfälle von einzelnen Komponenten oder des gesamten Batteriesystems verhindert werden können.

Eine in den Figuren nicht dargestellte Vorrichtung kann einen Prozessor mit Speicher aufweisen, der dazu eingerichtet ist, die Steuereinrichtung entsprechend zu konfigurieren, damit die oben zu Figur 2 erläuterten erfindungsgemäßen Schritte ausgeführt werden können. Eine Ausführungsform der Vorrichtung kann eine Erfassungseinrichtung, die die Ground-Truth-Werte erfasst, und ein Simulationsmodul aufweisen, das das Ersatzschaltbildmodell ECM und das thermische Zellmodell TM umfasst. Die Vorrichtung kann dann mit dem Neuronalen Netz NN gekoppelt sein (direkt oder fern angebunden) sein. Zusätzlich ist die Steuereinrichtung EMS mit der Vorrichtung gekoppelt (direkt oder fern angebunden). Fern angebunden kann mittels einer Funkverbindung nach gängigen Standards erfolgen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe/-schritte kann anhand von Instruktionen erfolgen, die auf computerlesbaren Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System abzulegen und darauf via Netzwerk zuzugreifen.

Unter "rechner-/computergestützt" bzw. "computerimplementiert" kann im Zusammenhang mit der Erfindung beispielsweise eine Implementierung des Verfahrens verstanden werden, bei dem insbesondere ein Prozessor, der Teil der (Steuerungs- /Rechen-) vorrichtung bzw. -einheit sein kann, mindestens einen Verfahrensschritt des Verfahrens ausführt.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein Speicher in Form von Arbeitsspeicher (engl. Random-Access Memory, RAM) oder eine Festplatte verstanden werden.

## Patentansprüche

1. Computerimplementiertes Verfahren zum Konfigurieren einer Steuereinrichtung (EMS) für einen Batteriespeicher (BS), wobei
a) eine Erfassungseinrichtung bereitgestellt wird, die dazu ausgestaltet ist, Ground-Truth-Werte (SOH, SOC) von am Batteriespeicher gemessenen physikalischen Größen über einen vorgebbaren Nutzungszeitraum zu erfassen,
b) ein Simulationsmodul bereitgestellt wird, das dazu ausgelegt ist, anhand von als Simulationseingabedaten eingespeisten an demselben Batteriespeicher oder an zumindest einem weiteren vergleichbaren Batteriespeicher gemessenen und/oder angenommenen Leistungsprofilen über einen mit dem Nutzungszeitraum vergleichbaren, vorgebbaren Zeitraum das Verhalten des Batteriespeichers und den erfassten und/oder vorgebbarer Ground-Truth-Werte elektrisch und/oder thermisch zu simulieren und aus der Simulation gewonnene zeitliche Verläufe von physikalischen Größen über den ganzen Zeitraum oder Teile des Zeitraums als Simulationsausgabedaten auszugeben,
c) durch das Simulationsmodul eine elektrische und/oder thermische Simulation anhand der Simulationseingabedaten durchgeführt wird und dabei die Simulationsausgabedaten ermittelt werden,
d) die Simulationsausgabedaten und die erfassten und/oder vorgebbaren Ground-Truth-Werte als Eingabedaten in ein neuronales Netz (NN) eingespeist werden,
e) das neuronale Netz darauf trainiert wird, einen aus den Eingabedaten bestimmbaren Batterieladezustand (SOC) und/oder bestimmbaren Alterungszustand (SOH) des Batteriespeichers zu prognostizieren und als Ausgabedaten zur Konfiguration der Steuereinrichtung auszugeben.

2. Verfahren nach dem vorhergehenden Anspruch, **dadurch gekennzeichnet, dass**
die Steuereinrichtung, welche einen internen und/oder externen Speicher aufweist, in dem das trainierte neuronale Netz vollständig oder zumindest in einer Speicherplatz-optimierten Form bereitgestellt wird, im Batteriespeicherbetrieb die physikalischen Größen misst und/oder erfasst, und mittels des Neuronalen Netzes einen oder mehrere Batterieladezustände und Alterungszustände prognostiziert und diese dazu nutzt, ein oder mehrere Steuermaßnahmen einzuleiten, wenn ein vorgebbarer Grenzwert für den Batterieladezustand und/oder Alterungszustand erreicht wird.

3. Verfahren nach einem der vorhergehenden Ansprüche, **dadurch gekennzeichnet, dass** Ausgabedaten des neuronalen Netzes in das Simulationsmodul als Simulationseingabedaten eingespeist werden und gegebenenfalls die Schritte b) bis e) von Anspruch 1 wiederholt werden.

4. Verfahren nach einem der vorhergehenden Ansprüche, **dadurch gekennzeichnet, dass** vor oder während der Simulation des Verhaltens des Batteriespeichers für den Betrieb des Batteriespeichers relevante Parameter, insbesondere Speicherkapazität, Innenwiderstand, Ruhepotential, elektrische Impedanz und/oder Alterungszustandsraten eingestellt werden.

5. Verfahren nach einem der vorhergehenden Ansprüche, **dadurch gekennzeichnet, dass** als weitere Eingabedaten Betriebsbedingungen, insbesondere Umgebungstemperatur, und/oder Batteriedesigninformationen, insbesondere geometrischer Aufbau und/oder elektrische Verschaltung von Batteriezellen und/oder -modulen angeschlossener Wechselrichtertyp, kumulierte Lastdauer und/oder kumulierte Ruhepausen in das neuronale Netz eingespeist werden.

6. Vorrichtung zum Konfigurieren einer Steuereinrichtung (EMS) für einen Batteriespeicher (BS), umfassend:
a) eine Erfassungseinrichtung, die dazu ausgestaltet ist, Ground-Truth-Werte von am Batteriespeicher gemessenen physikalischen Größen über einen vorgebbaren Nutzungszeitraum zu erfassen,
b) ein Simulationsmodul, das dazu ausgelegt ist, anhand von als Simulationseingabedaten eingespeisten an demselben Batteriespeicher oder an zumindest einem weiteren vergleichbaren Batteriespeicher gemessenen und/oder angenommenen Leistungsprofilen über einen mit dem Nutzungszeitraum vergleichbaren, vorgebbaren Zeitraum das Verhalten des Batteriespeichers und den erfassten und/oder vorgebbarer Ground-Truth-Werte elektrisch und/oder thermisch zu simulieren und aus der Simulation gewonnene zeitliche Verläufe von physikalischen Größen über den ganzen Zeitraum oder Teile des Zeitraums als Simulationsausgabedaten auszugeben,
c) ein mit der Vorrichtung gekoppeltes neuronales Netz (NN), in das die Simulationsausgabedaten und die erfassten und/oder vorgebbaren Ground-Truth-Werte als Eingabedaten eingespeist werden können und
d) das darauf trainiert wird, einen aus den Eingabedaten bestimmbaren Batterieladezustand (SOC) und/oder bestimmbaren Alterungszustand (SOH) des Batteriespeichers zu prognostizieren und als Ausgabedaten zur Konfiguration der Steuereinrichtung auszugeben.

7. Vorrichtung nach dem vorhergehenden Anspruch, **dadurch gekennzeichnet, dass** eine mit der Vorrichtung gekoppelte Steuereinrichtung (EMS), welche einen internen und/oder externen Speicher aufweist, der das trainierte neuronale Netz vollständig oder zumindest in einer Speicherplatz-optimierten Form umfasst, im Batteriespeicherbetrieb die physikalischen Größen misst und/oder erfasst und mittels des Neuronalen Netzes ein oder mehrere Batterieladezustände und Alterungszustände prognostiziert und diese dazu nutzt, ein oder mehrere Steuermaßnahmen einzuleiten, wenn ein vorgebbarer Grenzwert für den Batterieladezustand und/oder Alterungszustand erreicht wird.

8. Vorrichtung nach einem der vorhergehenden Vorrichtungsansprüche, **dadurch gekennzeichnet, dass** vor oder während der Simulation des Verhaltens des Batteriespeichers für den Betrieb des Batteriespeichers relevante Parameter, insbesondere Speicherkapazität, Innenwiderstand, Ruhepotential, elektrische Impedanz und/oder Alterungszustandsraten einstellbar sind.

9. Vorrichtung nach einem der vorhergehenden Vorrichtungsansprüche, **dadurch gekennzeichnet, dass** als weitere Eingabedaten Betriebsbedingungen, insbesondere Umgebungstemperatur, und/oder Batteriedesigninformationen, insbesondere geometrischer Aufbau und/oder elektrische Verschaltung von Batteriezellen und/oder -modulen angeschlossener Wechselrichtertyp, kumulierte Lastdauer und/oder kumulierte Ruhepausen in das neuronale Netz eingespeist werden können.

10. Computerprogrammprodukt, umfassend Befehle, die bei der Ausführung des Computerprogramms durch einen Computer diesen veranlassen, das Verfahren nach einem der vorhergehenden Verfahrensansprüche auszuführen.
